(19) Europäisches Patentamt
European Patent Office
Office européen des brevets

(11) **EP 4 764 546 A1**

(12) **EUROPEAN PATENT APPLICATION**
published in accordance with Art. 153(4) EPC

(43) Date of publication:
**24.06.2026 Bulletin 2026/26**

(21) Application number: **25790751.9**

(22) Date of filing: **05.03.2025**

(51) International Patent Classification (IPC):
*G01R 31/392* (2019.01)    *G01R 31/396* (2019.01)
*G01R 31/52* (2020.01)    *G01R 31/382* (2019.01)
*G01R 19/00* (2006.01)    *G01R 19/165* (2006.01)
*G01R 19/12* (2006.01)

(52) Cooperative Patent Classification (CPC):
**G01R 19/00; G01R 19/12; G01R 19/165;**
**G01R 31/382; G01R 31/392; G01R 31/396;**
**G01R 31/52;** Y02E 60/10

(86) International application number:
**PCT/KR2025/099564**

(87) International publication number:
**WO 2025/221127 (23.10.2025 Gazette 2025/43)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **16.04.2024 KR 20240050745**

(71) Applicant: **LG Energy Solution, Ltd.**
**Seoul 07335 (KR)**

(72) Inventor: **SUNG, Yong Chul**
**Daejeon 34122 (KR)**

(74) Representative: **Plasseraud IP**
**104 Rue de Richelieu**
**CS92104**
**75080 Paris Cedex 02 (FR)**

(54) **BATTERY MANAGEMENT APPARATUS AND OPERATION METHOD THEREOF**

(57)    A battery management device according to an embodiment disclosed in this document includes an interface configured to acquire a voltage profile representing a change in voltage of each of a plurality of battery cells over time and a processor configured to divide the voltage profile into a plurality of time sections and detect whether the plurality of battery cells are abnormal based on a first voltage parameter related to an average voltage of the plurality of battery cells corresponding to each of the plurality of time sections, and a second voltage parameter related to a difference between the first voltage parameters between adjacent time sections among the plurality of time sections.

FIG.1

**Description**

## TECHNICAL FIELD

### Cross-reference to Related Applications

This application claims priority from Korean Patent Application No. 10-2024-0050745, filed on April 16, 2024, the disclosure of which is incorporated by reference herein.

### Technical Field

Embodiments disclosed in this document relate to a battery management device and an operating method thereof.

## BACKGROUND ART

Recently, research and development on secondary batteries have been actively conducted. Here, secondary batteries are batteries that can be charged and discharged, and may be interpreted including both conventional Ni/Cd batteries, Ni/MH batteries, and recent lithium ion batteries. Among secondary batteries, lithium ion batteries have the advantage of having much higher energy density than conventional Ni/Cd batteries and Ni/MH batteries, etc. In addition, lithium ion batteries may be manufactured to be small and lightweight, and thus lithium ion batteries are used as power sources for mobile devices. Recently, the scope of use of the lithium ion batteries has expanded to include a power source for electric vehicles, and the lithium ion batteries are attracting attention as a next-generation energy storage medium.

Secondary batteries gradually degrade through repeated charging and discharging processes, but it is difficult to accurately predict and detect degradation or defects of secondary batteries. In order to predict abnormal behavior of secondary batteries, a method of predicting the characteristics of secondary batteries based on an open circuit voltage (OCV) of the secondary battery in a rest period is being used, but it is difficult to accurately detect the cause of abnormal behavior of secondary batteries based on the open circuit voltage in a rest period.

## DISCLOSURE OF THE INVENTION

### TECHNICAL PROBLEM

Embodiments disclosed in this document provide a battery management device and an operating method thereof for diagnosing the cause of abnormal behavior of a battery cell based on an open circuit voltage profile of the battery cell in a rest period.

The technical objectives of the embodiments disclosed in this document are not limited to the technical problems mentioned above, and other technical problems not mentioned can be clearly understood by those skilled in the art from the descriptions below.

## TECHNICAL SOLUTION

A battery management device according to an embodiment disclosed in this document includes an interface configured to acquire a voltage profile representing a change in voltage of each of a plurality of battery cells over time, and a processor configured to divide the voltage profile into a plurality of time sections and detect whether the plurality of battery cells are abnormal based on a first voltage parameter related to an average voltage of the plurality of battery cells corresponding to each of the plurality of time sections, and a second voltage parameter related to a difference between the first voltage parameters between adjacent time sections among the plurality of time sections.

According to an embodiment, the interface may be configured to acquire the voltage profile whenever an SoC of the plurality of battery cells reaches a preset threshold value, and a length of the most preceding time section among the plurality of time sections may be shorter than lengths of other time sections.

According to an embodiment, the first voltage parameter may include data related to an average change rate of an average voltage of the plurality of battery cells in each of the plurality of time sections.

According to an embodiment, the second voltage parameter may correspond to a difference value between first parameters each corresponding to each of adjacent time sections among the plurality of time sections.

According to an embodiment, the processor may be configured to compute a deviation between the second voltage parameters based on Equation 1 below,

$$[\text{Equation 1}]$$

$$X = \frac{(V_2(T) - V_1(T)) - (V_2(T) - V_1(T))}{V_1(T)}$$

(where, X corresponds to a deviation between the second voltage parameters, $V_2(t)$ corresponds to the second voltage parameter, $V_1(t)$ corresponds to the first voltage parameter, and a time section T-1 corresponds to a time section adjacent to a time section T).

According to an embodiment, the processor may detect that a battery cell of which a tab is disconnected exists among the plurality of battery cells when the deviation between the second parameters is greater than a preset reference value.

An operating method of a battery management device according to an embodiment disclosed in this document may include acquiring a voltage profile representing a change in voltage of each of a plurality of battery cells over time, dividing the voltage profile into a plurality of time sections, computing an average voltage of the plurality of battery cells corresponding to each of the plurality of time sections, computing an average change rate of the average voltage of the plurality of battery cells in each of the plurality of time sections, and detecting an abnormality in the plurality of battery cells based on a deviation between the average change rates in adjacent time sections among the plurality of time sections.

According to an embodiment, the voltage profile may include data representing a change in voltage of each of the plurality of battery cells over time from a point in time when the plurality of battery cells reach a charge completion state or discharge completion state.

According to an embodiment, a length of the most preceding time section among the plurality of time sections may be shorter than lengths of other time sections.

According to an embodiment, the deviation between the average change rates may be computed based on Equation 1 below,

[Equation 1]

$$X = \frac{(V_2(T) - V_1(T)) - (V_2(T) - V_1(T))}{V_1(T)}$$

(where, X corresponds to the deviation between the average change rates, $V_2(t)$ corresponds to the difference between the average change rates in adjacent time sections, $V_1(t)$ corresponds to the average change rates, and time point T-1 corresponds to a time point adjacent to time point T).

According to an embodiment, the detecting of the abnormality in the plurality of battery cells may include detecting that a battery cell of which a tab is disconnected exists among the plurality of battery cells when the deviation is greater than a preset reference value.

## ADVANTAGEOUS EFFECTS

A battery management device according to an embodiment disclosed in this document can effectively detect a tab disconnection of a battery cell.

Technical effects according to an embodiment disclosed in this document are not limited to the effects mentioned above, and other effects not mentioned will be clearly understood by those skilled in the art according to the disclosure of this document.

## BRIEF DESCRIPTION OF THE DRAWINGS

FIG. 1 is a diagram for describing a battery pack according to an embodiment disclosed in this document.
FIG. 2 is a diagram for describing a battery management device according to an embodiment disclosed in this document.
FIG. 3 is a graph for describing a voltage profile according to an embodiment disclosed in this document.
FIG. 4 is a graph for describing a voltage parameter according to an embodiment disclosed in this document.
FIG. 5 is a flowchart for describing an operation of a battery management device according to an embodiment disclosed in this document.
FIG. 6 is a diagram for describing a computing system equipped with a battery management device according to an embodiment disclosed in this document.

## MODE FOR CARRYING OUT THE INVENTION

Hereinafter, embodiments disclosed in this document will be described in detail with exemplary drawings. When adding reference numerals to components in each drawing, it should be noted that the same components are given the same reference numerals as much as possible even if they are shown in different drawings. In addition, when describing the embodiments disclosed in this document, if a specific description of a related known configuration or function is determined to hinder understanding of the embodiments disclosed in this document, the detailed description thereof is omitted.

In describing the components of the embodiments disclosed in this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

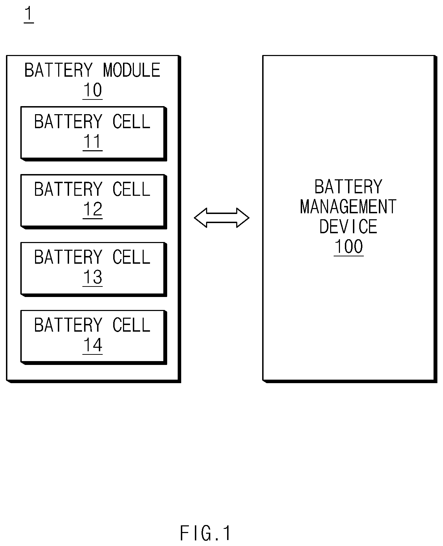

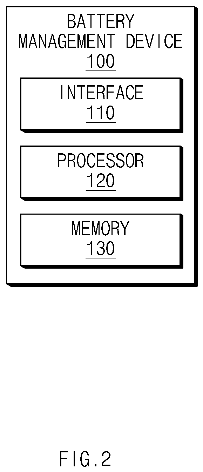

FIG. 1 is a diagram for describing a battery pack according to an embodiment disclosed in this document, and FIG. 2 is a diagram for describing a battery management device according to an embodiment disclosed in this document.

First, referring to FIG. 1, a battery pack 1 may include a battery module 10 and a battery management device 100.

The battery module 10 may include a plurality of battery cells 11, 12, 13, and 14. In FIG. 1, the battery module 10 is illustrated as including four battery cells, but is not limited thereto, and the battery module 10 may include n (n is a natural number of 2 or more) battery cells.

The plurality of battery cells 11, 12, 13, and 14 may be, but are not limited to, Li-ion batteries, Li-ion polymer batteries, Ni-Cd batteries, nickel metal hydride (Ni-MH) batteries, etc. In addition, although the battery pack 1 in FIG. 1 is illustrated as including one battery module 10, the battery pack 1 may include n (n is a natural number of 2 or more) battery modules according to an embodiment.

The battery pack 1 may be configured to supply power to a target device (not shown). To this end, the battery pack 1 may be electrically connected to the target device. Here, the target device may include any electrical, electronic, or mechanical device that operates by receiving power from the battery pack 1. For example, the target device may be a two-wheeled electric vehicle such as an electric vehicle (EV) or an electric scooter, but is not limited thereto. In addition, when the target device is a two-wheeled electric vehicle such as an electric scooter, the battery pack 1 mounted on the two-wheeled electric vehicle may be replaceable through a battery swapping station (BSS).

The battery diagnosis device 100 may manage and/or control a state and/or operation of the battery module 10. For example, the battery diagnosis device 100 may manage and/or control the state and/or operation of the plurality of battery cells 11, 12, 13, and 14 included in the battery module 10, or manage charging and/or discharging of the battery module 10.

The battery diagnosis device 100 may monitor the voltage, current, temperature, etc. of the battery module 10 and each of the plurality of battery cells 11, 12, 13, and 14. To this end, sensors or various measuring modules not shown in FIG. 1 may be additionally installed at any location or in a charging and discharging path inside the battery module 10 or the battery pack 1.

The battery diagnosis device 100 may calculate parameters indicating the state of the battery module 10, such as a state of charge (SOC) or state of health (SOH), based on measured values such as monitored voltage, current, and temperature.

The battery management device 100 may be configured to diagnose a degradation degree of the plurality of battery cells 11, 12, 13, and 14 and/or detect a battery cell in which an abnormality has occurred among the plurality of battery cells 11, 12, 13, and 14. Details related to this will be described below in the description of FIG. 2.

Referring to FIG. 2, the battery management device 100 may include an interface 110, a processor 120, and a memory 130.

The interface 110 may acquire a voltage profile of each of the plurality of battery cells 11, 12, 13, and 14 (see FIG. 1). Here, the voltage profile may include, but is not limited to, a graph showing a change in voltage of each of the plurality of battery cells 11, 12, 13, and 14 over time. The interface 110 may measure and/or predict the voltage of each of the plurality of battery cells 11, 12, 13, and 14 based on the current flowing in the battery pack 1 (see FIG. 1) and/or the internal resistance thereof.

According to an embodiment, the interface 110 may acquire a voltage profile by applying a voltage and/or current to the plurality of battery cells 11, 12, 13, and 14. In this case, the interface 110 may include various circuits for applying the voltage and/or current to the plurality of battery cells 11, 12, 13, and 14 and a processor for computing and/or processing the acquired voltage profile.

According to an embodiment, the interface 110 may indirectly acquire the voltage profile of each of the plurality of battery cells 11, 12, 13, and 14. In this case, the interface 110 may further include a communication module for communicating with the battery pack 1 in a wired manner and/or wirelessly.

According to an embodiment, the interface 110 may acquire the voltage profiles of the plurality of battery cells 11, 12, 13, and 14 whenever a state of charge (SoC) of each of the plurality of battery cells 11, 12, 13, and 14 reaches a preset threshold value. Here, the preset threshold value may be 100% or 0%, which is a value indicating a state in which charging is completed and/or discharging is completed, but is not limited thereto. The interface 110 may acquire the voltage profiles that represent the change in voltage of each of the plurality of battery cells 11, 12, 13, and 14 over time from the point in time when charging of each of the plurality of battery cells 11, 12, 13, and 14 is completed and/or discharging thereof is completed.

According to an embodiment, the interface 110 may acquire the voltage profile of each of the plurality of battery cells 11, 12, 13, and 14 until the voltage of each of the plurality of battery cells 11, 12, 13, and 14 reaches a resting voltage.

The processor 120 may control the overall operation of the battery management device 100. Here, the processor may execute software to control an operation of at least one other component (e.g., hardware or software) of the battery management device 100, or perform operations such as processing and/or computing various data. In addition, referring to FIG. 2, the battery management device 100 is illustrated as including one processor 120, but is not limited thereto, and the battery management device 100 may be configured to include at least one processor.

The processor 120 may be configured to detect a battery cell in which an abnormality has occurred among the plurality of battery cells 11, 12, 13, and 14 based on the voltage profile of each of the plurality of battery cells 11, 12, 13, and 14. The processor 120 may compute various voltage parameters for detecting an abnormality in the plurality of battery cells 11, 12, 13, and 14 based on the voltage profiles of each of the plurality of battery cells 11, 12, 13, and 14.

According to an embodiment, the processor 120 may divide the voltage profile of each of the plurality of battery cells 11, 12, 13, and 14 into a plurality of time sections. The processor 120 may compute various voltage parameters based on the voltage profiles of the plurality of battery cells 11, 12, 13, and 14 each voltage profile corresponding to each of the divided time sections. Here, the lengths of respective time sections may be the same or different from each other, and are not limited to a specific example.

The processor 120 may compute a first voltage parameter and a second voltage parameter for detecting an abnormality in the plurality of battery cells 11, 12, 13, and 14 based on the voltage profiles in each of the plurality of time sections. According to an embodiment, the first voltage parameter may be related to an average voltage of the plurality of battery cells 11, 12, 13, and 14, and the second voltage parameter may be related to a difference between the first voltage parameters in adjacent time sections.

According to an embodiment, the first voltage parameter may be computed based on an average voltage of the plurality of battery cells 11, 12, 13, and 14 in each of the plurality of time sections. For example, the first voltage parameter may be related to an average voltage, which is an average value of the voltages of the plurality of battery cells 11, 12, 13, and 14 in each of the plurality of time sections, and the first voltage parameter may include, but is not limited to, data related to an average change rate of the average voltage of the plurality of battery cells 11, 12, 13, and 14 in each of the plurality of time sections.

According to an embodiment, the second voltage parameter may include, but is not limited to, data related to a difference between the first voltage parameters between adjacent time sections among the plurality of time sections, that is, the average change rate of the average voltage of the plurality of battery cells 11, 12, 13, and 14 in each of the plurality of time sections. Here, the adjacent time sections may be one of the preceding time section and/or the following time sections, and is not limited to a specific example.

The processor 120 may compute a deviation of the second voltage parameter. According to an embodiment, the processor 120 may detect an abnormality in the plurality of battery cells 11, 12, 13, and 14 based on a comparison result between the computed deviation of the second voltage parameter and a preset reference value. For example, when the deviation of the second voltage parameter is greater than the preset reference value, the processor 120 may diagnose that a battery cell of which a tab is disconnected exists among the plurality of battery cells 11, 12, 13, and 14. As another example, when the deviation of the second voltage parameter is smaller than the preset reference value, the processor 120 may diagnose that polarization in the plurality of battery cells 11, 12, 13, and 14 has occurred.

The memory 130 may store various data (e.g., instructions, data related to mathematical formulas, voltage profiles of a plurality of battery cells, data related to reference values) for the operation of the battery diagnosis device 100. According to an embodiment, the memory 130 may include, but is not limited to, a volatile memory device such as a static random access memory (SRAM) or a dynamic random access memory (DRAM) or a non-volatile memory device such as a read only memory (ROM), a programmable ROM (PROM), or a flash memory.

According to an embodiment, the battery management device 100 may be formed integrally with the battery pack 1 (see FIG. 1). In this case, the battery management device 100 may be implemented as a module battery management system (BMS) that controls the overall operation of the battery module 10 (see FIG. 1) or a pack BMS that controls the overall operation of the battery pack 1, but is not limited thereto.

According to an embodiment, the battery management device 100 may be formed separately from the battery pack 1. In this case, the battery management device 100 may be connected to the battery module 10 and/or the battery pack 1 including the battery module 10 through a wired and/or wireless network, etc., and may be implemented through various devices such as a cloud server, a charger, and a charger/discharger.

According to an embodiment, the battery management device 100 may transmit a degradation degree (e.g., SOH), diagnosis results, etc. of each of the plurality of battery cells 11, 12, 13, and 14 to an external device (e.g., a cloud server or a user terminal). The cloud server may be configured to provide the degradation degree and/or diagnosis results, etc. of the plurality of battery cells 11, 12, 13, and 14 to a plurality of users. Here, the user terminal may include a personal computer (PC) or a terminal such as a smartphone, but is not limited thereto.

According to an embodiment, the battery management device 100 may be implemented through the battery swapping station (BSS). Here, the BSS may be a system having a slot into which the battery pack 1 may be inserted and capable of charging the inserted battery pack 1.

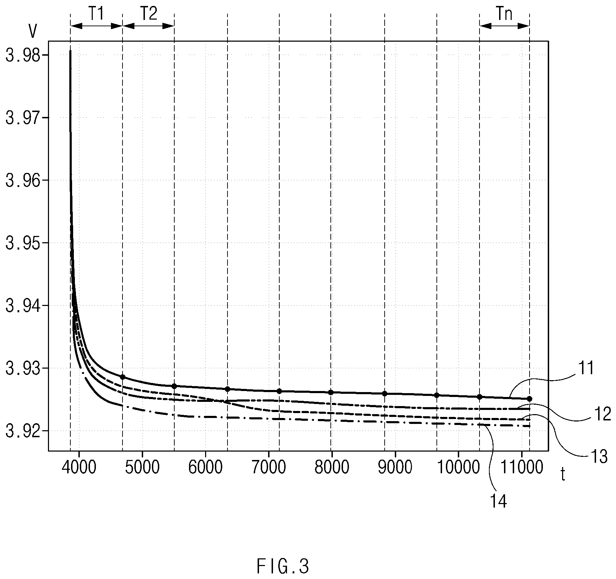

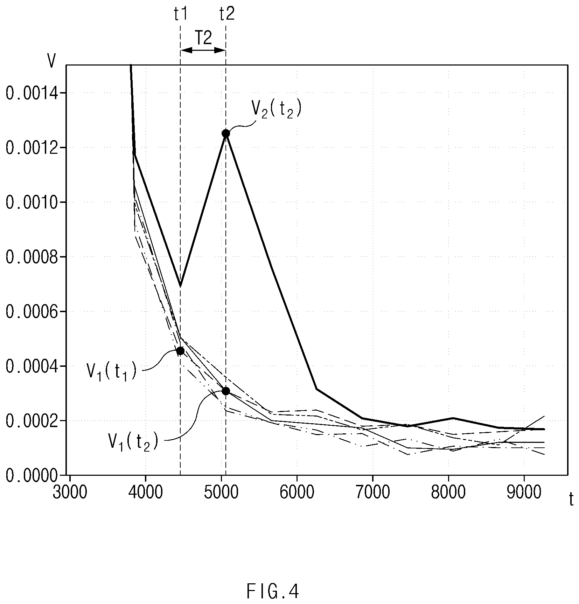

FIG. 3 is a graph for describing a voltage profile according to an embodiment disclosed in this document, and FIG. 4 is a graph for describing a voltage parameter according to an embodiment disclosed in this document.

First, referring to FIG. 3, a plurality of voltage profiles related to a change in voltage of each of the plurality of battery cells 11, 12, 13, and 14 (see FIG. 1) over time are illustrated.

According to an embodiment, the horizontal axis of the graph illustrated in FIG. 3 may represent time t (sec) and the vertical axis may represent voltage V. For convenience of description, the plurality of battery cells 11, 12, 13, and 14 are assumed to be in a charging state and described, but this is not limited thereto, and the same may be applied to battery cells in a discharging state.

After charging of the plurality of battery cells 11, 12, 13, and 14 is completed, each of the plurality of battery cells 11, 12, 13, and 14 enters a rest state. The voltage of each of the plurality of battery cells 11, 12, 13, and 14 gradually decreases as it enters the rest state, and, from the point in time of approximately about 4000 seconds has elapsed, the voltage of each of the plurality of battery cells 11, 12, 13, and 14 gradually converges to a resting voltage in which the amount of change is not large.

The processor 120 (see FIG. 2) may divide the voltage profile of each of the plurality of battery cells 11, 12, 13, and 14 into a plurality of time sections. According to an embodiment, the processor 120 may divide the time section from the point in time when each of the plurality of battery cells 11, 12, 13, and 14 enters the rest state into n (n is a positive integer) time sections. As shown in FIG. 3, the most preceding time section may be the T1 section, which is the first time section, and the latest following time section may be the Tn section, which is the last time section.

According to an embodiment, lengths of respective time sections of the plurality of time sections T1 to Tn may be the same and/or different from each other.

According to an embodiment, when the lengths of respective time sections of the plurality of time sections T1 to Tn are different from each other, the processor 120 may the length of the T1 section, which is the most preceding time section, may be shorter than the lengths of the other time sections T2 to Tn. This is because the voltage change of the battery cells 11, 12, 13, and 14 that have entered the rest state appears relatively large in the relatively preceding time sections. In order to effectively detect such voltage change, the processor 120 may set the length of T1, which is the most preceding time section, to be shorter than the lengths of the other time sections. However, this is an example, and the processor 120 may set the length of the time section in various ways, such as setting the length of the most preceding time sections to be shorter than the lengths of other time sections, depending on the design.

The processor 120 may compute the average voltage of respective cells of the plurality of battery cells 11, 12, 13, and 14 in each of the plurality of time sections. For example, the processor 120 may compute the average voltage of respective cells of the plurality of battery cells 11, 12, 13, and 14 for the first time section T1 and generate a graph representing the average voltage of the plurality of battery cells 11, 12, 13, and 14 for the first time section T1. Likewise, the processor 120 may compute the average of the voltages of respective cells of the plurality of battery cells 11, 12, 13, and 14 for the second time section T2 following the first time section T1, and the processor 120 may compute the average of the voltages of respective cells of the plurality of battery cells 11, 12, 13, and 14 for each of all time sections T1 to Tn to generate a graph representing the average voltages of the plurality of battery cells 11, 12, 13, and 14.

The processor 120 may compute an average change rate of the average voltages of respective cells of the plurality of battery cells 11, 12, 13, and 14 in each of all time sections T1 to Tn. Here, the average change rate may be defined as the average voltage change rate per unit time, and the average voltage of respective cells of the plurality of battery cells 11, 12, 13, and 14 and the average change rate of the average voltage of respective cells of the plurality of battery cells 11, 12, 13, and 14 computed based on the average voltage may be included in the first voltage parameter, but is not limited thereto.

The processor 120 may compute the second voltage parameter related to the difference between the average change rates based on the average change rate of the average voltage of respective cells of the plurality of battery cells 11, 12, 13, and 14 in each of all time sections T1 to Tn. According to an embodiment, the processor 120 may compute a difference between the average change rate of the average voltage of the plurality of battery cells 11, 12, 13, and 14 corresponding to the second time section T2 and the average change rate of the average voltage of the plurality of battery cells 11, 12, 13, and 14 corresponding to the first time section T1, and compute a difference between the average change rate of the average voltage of the plurality of battery cells 11, 12, 13, and 14 corresponding to the third time section T3 and the average change rate of the average voltage of the plurality of battery cells 11, 12, 13, and 14 corresponding to the second time section T2. Likewise, the processor 120 may repeat the computation operation described above until a difference between an average change rate of the average voltage of the plurality of battery cells 11, 12, 13, and 14 corresponding to an n-th time section Tn and an average change rate of the average voltage of the plurality of battery cells 11, 12, 13, and 14 corresponding to an (n-1)-th time section Tn-1 is computed.

In this regard, referring to FIG. 4, a graph showing a relationship between a first voltage parameter and a second voltage parameter is illustrated. As illustrated in FIG. 3, the horizontal axis of the graph illustrated in FIG. 4 may represent time t, and the vertical axis may represent voltage V.

Referring to FIG. 4, a second time section T2 may be a time section between a point in time t1 and a point in time t2. The processor 120 (see FIG. 1) may compute a first voltage parameter V1 of each of a second time section T2 and a first time section T1, which is the time section preceding the second time section T2. Here, a first voltage parameter V1(t1) at the point in time t1 may correspond to a first voltage parameter value for the first time section T1, and a first voltage parameter V1(t2) at the point in time t2 may correspond to the first voltage parameter value for the second time section T2.

According to an embodiment, the processor 120 may compute a difference between the first voltage parameter for the second time section T2 and the first voltage parameter for the first time section T1. Here, a difference between the first voltage parameter for an n-th time section Tn and the first voltage parameter for an (n-1)-th time section Tn-1 may be defined as V2(tn). That is, as illustrated in FIG. 4, a second voltage parameter V2(t2) at the point in time t2 may correspond to the difference value between the first voltage parameters for the second time section T2 and the first time section T1.

According to an embodiment, the processor 120 may compute the second voltage parameter through various data processing methods. For example, the processor 120 may compute a deviation described below based on an absolute value of a value of the computed second voltage parameter, but is not limited thereto.

The processor 120 may compute the deviation between the second voltage parameters. According to an embodiment, the processor 120 may compute the deviation between the second voltage parameters based on Equation 1 below.

[Equation 1]

$$X = \frac{(V_2(T) - V_1(T)) - (V_2(T) - V_1(T))}{V_1(T)}$$

(Here, X corresponds to the deviation of the second voltage parameter, $V_2(t)$ corresponds to the second voltage parameter, $V_1(t)$ corresponds to the first voltage parameter, and a time section T-1 corresponds to a time section adjacent to a time section T.)

For example, when computing the deviation corresponding to the second time section T2, the processor 120 may compute a deviation X value based on the first voltage parameter and the second voltage parameter of each of the second time section T2 and the first time section T1.

Here, the processor 120 may compute the deviation X value corresponding to each of all time sections. When a deviation value greater than a preset reference value exists among the computed deviation values, the processor 120 may detect that, among a plurality of battery cells, there is a battery cell in which an abnormal voltage behavior has occurred due to a voltage inflection phenomenon caused by a tap disconnection.

The voltage profile of the battery cell until entering a rest section after the charging/discharging operation of the battery cell exhibits various behaviors depending on the state of the battery cell. The battery management device 100 (see FIG. 1) according to an embodiment disclosed in this document can detect abnormal behavior of voltage due to defective tab disconnection of a battery cell and abnormal behavior of voltage due to a polarization difference. Voltage changes due to voltage inflection tend to rise momentarily at the beginning of the rest section, whereas voltage changes due to polarization tend to fall continuously during the rest section. The battery management device 100 may effectively detect the instantaneous voltage change due to polarization by appropriately dividing a time section in a section where the instantaneous voltage rise appears and computing the deviation of the voltage parameter between adjacent time sections.

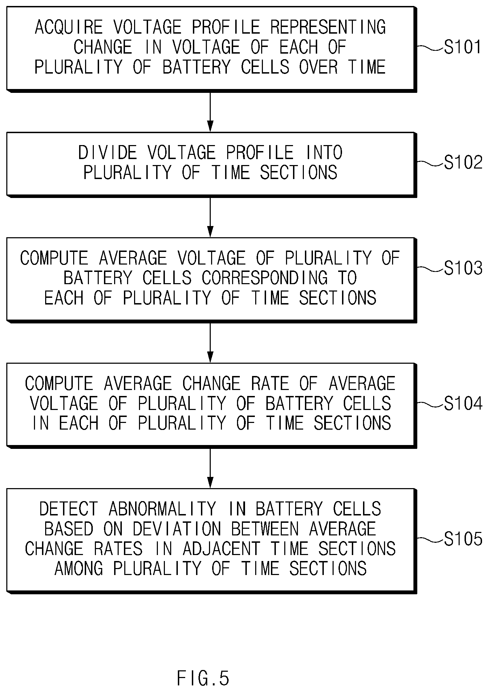

FIG. 5 is a flowchart for describing an operation of a battery management device according to an embodiment disclosed in this document.

In step S101, the battery management device 100, (see FIG. 1) may acquire a voltage profile representing a change in voltage of each of a plurality of battery cells 11, 12, 13, and 14 over time.

According to an embodiment, the voltage profile may include data representing a change in voltage of each of the plurality of battery cells 11, 12, 13, and 14 over time from the point in time when the plurality of battery cells 11, 12, 13, and 14 reach a charge completion state or discharge completion state.

In step S102, the battery management device 100 may divide the voltage profile into a plurality of time sections.

Here, the battery management device 100 may set lengths of respective cells of the plurality of time sections to be the same or different from each other. According to an embodiment, the length of the most preceding time section and/or the most preceding time section among the plurality of time sections may be shorter than the lengths of other time sections. However, the embodiment disclosed in this document is not limited to this example, and the lengths of the most preceding time section and a preset number of time sections from the most preceding time section may be set in various ways, such as being set shorter than the lengths of other time sections.

In step S103, the battery management device 100 may compute an average voltage, which is an average of the voltages of the plurality of battery cells 11, 12, 13, and 14 corresponding to each of the plurality of time sections.

In step S104, the battery management device 100 may compute an average change rate of the average voltage of the plurality of battery cells 11, 12, 13, and 14 in each of the plurality of time sections. Here, the average voltage of the plurality of battery cells 11, 12, 13, and 14 may correspond to an average voltage computed based on step S103.

In step S105, the battery management device 100 may detect an abnormality in the plurality of battery cells 11, 12, 13, and 14 based on the deviation between the average change rates in adjacent time sections among the plurality of time sections.

According to an embodiment, the battery management device 100 may compute the deviation between the average change rates based on Equation 1 described above, but is not limited thereto.

According to an embodiment, when the computed deviation is greater than a preset reference value, the battery management device 100 may detect that a battery cell of which a tab is disconnected exists among the plurality of battery cells 11, 12, 13, and 14.

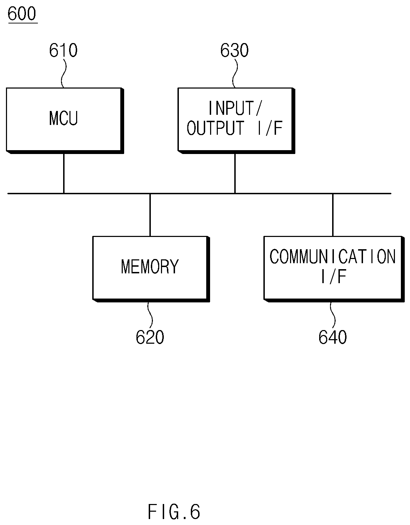

FIG. 6 is a diagram for describing a computing system equipped with a battery management device according to an embodiment disclosed in this document.

Referring to FIG. 6, a computing system 600 may include an MCU 610, a memory 620, an input/output I/F 630, and a communication I/F 640.

The MCU 610 may be a processor that executes various programs (e.g., battery cell diagnostic program, etc.) stored in the memory 620, processes various data for detecting an abnormality in the plurality of battery cells 11, 12, 13, and 14 (see FIG. 1) through these programs, and performs functions of the battery management device 100 described with reference to FIG. 2.

The memory 620 may store various programs for detecting abnormalities in battery cells. In addition, the memory 620 may store various data generated in the process of detecting an abnormality in a battery cell, such as information on time section length, deviation, first and second voltage parameters, etc.

A plurality of memories 620 may be provided as needed. The memory 620 may be a volatile memory or a nonvolatile memory. The memory 620 as a volatile memory may be RAM, DRAM, SRAM, etc. The memory 620 as a nonvolatile memory may be ROM, PROM, EAROM, EPROM, EEPROM, flash memory, etc. The examples of the memories 820 listed above are only examples and are not limited to these examples.

The input/output I/F 630 may provide an interface that enables data to be transmitted and received between an input device (not shown), such as a keyboard, mouse, or touch panel and an output device (not shown), such as a display, and the MCU 610.

The communication I/F 840 is a configuration that can transmit and receive various data with a server, and may be various devices that can support wired or wireless communication. For example, a program or various data for predicting the degradation degree of a battery cell, etc. can be transmitted and received from a separately provided external server through the communication I/F 640.

In this way, the battery cell abnormality detection method according to an embodiment disclosed in this document can be recorded in the memory 620 and executed by the MCU 610.

In the above, all components constituting the embodiment have been described as being combined as one or operating in combination, but are not necessarily limited to such an embodiment, and may operate by selectively combining one or more of them within the scope of the purpose. In addition, the terms "include," "configure," or "have" described above, unless specifically stated to the contrary, mean that the corresponding component may be included therein, and therefore should be interpreted as further including other components rather than excluding other components.

The above description is merely an illustrative description of the technical idea disclosed in this document, and those skilled in the art to which the embodiments disclosed in this document belong may make various modifications and variations without departing from the essential characteristics of the embodiments disclosed in this document.

Accordingly, the embodiments disclosed in this document are not intended to limit the technical ideas of the embodiments disclosed in this document, but rather to describe them, and the scope of the technical ideas disclosed in this document is not limited by these embodiments. The scope of protection of the technical ideas disclosed in this document should be interpreted by the scope of the claims below, and all technical ideas within the scope equivalent thereto should be interpreted as being included in the scope of the rights of this document.

**Claims**

1. A battery management device comprising:

   an interface configured to acquire a voltage profile representing a change in voltage of each of a plurality of battery cells over time; and
   a processor configured to divide the voltage profile into a plurality of time sections and detect whether the plurality of battery cells are abnormal based on a first voltage parameter related to an average voltage of the plurality of battery cells corresponding to each of the plurality of time sections, and a second voltage parameter related to a difference between the first voltage parameters between adjacent time sections among the plurality of time sections.

2. The battery management device of claim 1, wherein the interface is configured to acquire the voltage profile whenever an SoC of the plurality of battery cells reaches a preset threshold value, and a length of the most preceding time section among the plurality of time sections is shorter than lengths of other time sections.

3. The battery management device of claim 2, wherein the first voltage parameter includes data related to an average change rate of an average voltage of the plurality of battery cells in each of the plurality of time sections.

4. The battery management device of claim 3, wherein the second voltage parameter corresponds to a difference value between first parameters each corresponding to each of adjacent time sections among the plurality of time sections.

5. The battery management device of claim 4, wherein the processor is configured to compute a deviation between the second voltage parameters based on

Equation 1 below,

[Equation 1]

$$X = \frac{(V_2(T) - V_1(T)) - (V_2(T) - V_1(T))}{V_1(T)}$$

(where, X corresponds to a deviation between the second voltage parameters, $V_2(t)$ corresponds to the second voltage parameter, $V_1(t)$ corresponds to the first voltage parameter, and a time section T-1 corresponds to a time section adjacent to a time section T).

6. The battery management device of claim 5, wherein the processor detects that a battery cell of which a tab is disconnected exists among the plurality of battery cells when the deviation between the second parameters is greater than a preset reference value.

7. An operating method of a battery management device, comprising:

acquiring a voltage profile representing a change in voltage of each of a plurality of battery cells over time;
dividing the voltage profile into a plurality of time sections;
computing an average voltage of the plurality of battery cells corresponding to each of the plurality of time sections;
computing an average change rate of the average voltage of the plurality of battery cells in each of the plurality of time sections; and
detecting an abnormality in the plurality of battery cells based on a deviation between the average change rates in adjacent time sections among the plurality of time sections.

8. The operating method of claim 7, wherein the voltage profile includes data representing a change in voltage of each of the plurality of battery cells over time from a point in time when the plurality of battery cells reach a charge completion state or discharge completion state.

9. The operating method of claim 8, wherein a length of the most preceding time section among the plurality of time sections is shorter than lengths of other time sections.

10. The operating method of claim 7, wherein the deviation between the average change rates is computed based on Equation 1 below,

[Equation 1]

$$X = \frac{(V_2(T) - V_1(T)) - (V_2(T) - V_1(T))}{V_1(T)}$$

(where, X corresponds to the deviation between the average change rates, $V_2(t)$ corresponds to the difference between the average change rates in adjacent time sections, $V_1(t)$ corresponds to the average change rates, and time point T-1 corresponds to a time point adjacent to time point T).

11. The operating method of claim 10, wherein the detecting of the abnormality in the plurality of battery cells includes detecting that a battery cell of which a tab is disconnected exists among the plurality of battery cells when the deviation is greater than a preset reference value.

1

```
┌─────────────────────────────┐      ┌─────────────────────┐
│  BATTERY MODULE             │      │                     │
│         10                  │      │                     │
│  ┌───────────────────────┐  │      │                     │
│  │  BATTERY CELL         │  │      │                     │
│  │        11             │  │      │                     │
│  └───────────────────────┘  │      │                     │
│  ┌───────────────────────┐  │      │     BATTERY         │
│  │  BATTERY CELL         │  │      │   MANAGEMENT        │
│  │        12             │  │ ◁═══▷│    DEVICE           │
│  └───────────────────────┘  │      │      100            │
│  ┌───────────────────────┐  │      │                     │
│  │  BATTERY CELL         │  │      │                     │
│  │        13             │  │      │                     │
│  └───────────────────────┘  │      │                     │
│  ┌───────────────────────┐  │      │                     │
│  │  BATTERY CELL         │  │      │                     │
│  │        14             │  │      │                     │
│  └───────────────────────┘  │      │                     │
└─────────────────────────────┘      └─────────────────────┘
```

FIG.1

BATTERY
MANAGEMENT DEVICE
100

INTERFACE
110

PROCESSOR
120

MEMORY
130

FIG.2

FIG.3

FIG.4

```
┌─────────────────────────────────────┐
│  ACQUIRE VOLTAGE PROFILE REPRESENTING │
│      CHANGE IN VOLTAGE OF EACH OF     │ ～S101
│   PLURALITY OF BATTERY CELLS OVER TIME│
└─────────────────────────────────────┘
                   │
                   ▼
┌─────────────────────────────────────┐
│        DIVIDE VOLTAGE PROFILE INTO    │ ～S102
│        PLURALITY OF TIME SECTIONS     │
└─────────────────────────────────────┘
                   │
                   ▼
┌─────────────────────────────────────┐
│  COMPUTE AVERAGE VOLTAGE OF PLURALITY OF│
│      BATTERY CELLS CORRESPONDING TO    │ ～S103
│   EACH OF PLURALITY OF TIME SECTIONS   │
└─────────────────────────────────────┘
                   │
                   ▼
┌─────────────────────────────────────┐
│  COMPUTE AVERAGE CHANGE RATE OF AVERAGE│
│  VOLTAGE OF PLURALITY OF BATTERY CELLS │ ～S104
│   IN EACH OF PLURALITY OF TIME SECTIONS│
└─────────────────────────────────────┘
                   │
                   ▼
┌─────────────────────────────────────┐
│   DETECT ABNORMALITY IN BATTERY CELLS  │
│    BASED ON DEVIATION BETWEEN AVERAGE  │ ～S105
│  CHANGE RATES IN ADJACENT TIME SECTIONS│
│     AMONG PLURALITY OF TIME SECTIONS   │
└─────────────────────────────────────┘
```

FIG.5

600

610

630

MCU

INPUT/
OUTPUT I/F

MEMORY

COMMUNICATION
I/F

620

640

FIG.6

## INTERNATIONAL SEARCH REPORT

| International application No. |
| --- |
| **PCT/KR2025/099564** |

| A. | CLASSIFICATION OF SUBJECT MATTER |
| --- | --- |

**G01R 31/392**(2019.01)i; **G01R 31/396**(2019.01)i; **G01R 31/52**(2020.01)i; **G01R 31/382**(2019.01)i; **G01R 19/00**(2006.01)i; **G01R 19/165**(2006.01)i; **G01R 19/12**(2006.01)i

According to International Patent Classification (IPC) or to both national classification and IPC

| B. | FIELDS SEARCHED |
| --- | --- |

Minimum documentation searched (classification system followed by classification symbols)

G01R 31/392(2019.01); G01R 19/00(2006.01); G01R 31/36(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 전압(voltage), 인터페이스(interface), 시구간(time interval), 평균 (average)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | KR 10-2023-0166047 A (LG ENERGY SOLUTION, LTD.) 06 December 2023 (2023-12-06)<br>See paragraphs [0007], [0016], [0018], [0091], [0093] and [0134]; and claim 19. | 1-11 |
| A | KR 10-2022-0001364 A (LG ENERGY SOLUTION, LTD.) 05 January 2022 (2022-01-05)<br>See paragraphs [0013]-[0027]. | 1-11 |
| A | KR 10-2022-0015790 A (LG ENERGY SOLUTION, LTD.) 08 February 2022 (2022-02-08)<br>See paragraphs [0012]-[0026]. | 1-11 |
| A | KR 10-2010-0084935 A (DAEWOO ELECTRONICS CORPORATION) 28 July 2010 (2010-07-28)<br>See paragraphs [0023]-[0037]. | 1-11 |
| A | KR 10-2105170 B1 (SAMSUNG ELECTRONICS CO., LTD.) 24 April 2020 (2020-04-24)<br>See paragraphs [0068]-[0076]. | 1-11 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **04 June 2025** | **04 June 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2025/099564**

| Patent document cited in search report | | | Publication date (day/month/year) | Patent family member(s) | | | Publication date (day/month/year) |
|---|---|---|---|---|---|---|---|
| KR | 10-2023-0166047 | A | 06 December 2023 | CN | 118043690 | A | 14 May 2024 |
| | | | | EP | 4394404 | A1 | 03 July 2024 |
| | | | | EP | 4394404 | A4 | 12 March 2025 |
| | | | | JP | 2025-507568 | A | 21 March 2025 |
| | | | | KR | 10-2024-0019187 | A | 14 February 2024 |
| | | | | KR | 10-2632629 | B1 | 02 February 2024 |
| | | | | US | 12085626 | B2 | 10 September 2024 |
| | | | | US | 2023-0384393 | A1 | 30 November 2023 |
| | | | | US | 2024-0027540 | A1 | 25 January 2024 |
| | | | | US | 2024-0393406 | A1 | 28 November 2024 |
| | | | | WO | 2023-229326 | A1 | 30 November 2023 |
| KR | 10-2022-0001364 | A | 05 January 2022 | None | | | |
| KR | 10-2022-0015790 | A | 08 February 2022 | CN | 115280170 | A | 01 November 2022 |
| | | | | EP | 4148446 | A1 | 15 March 2023 |
| | | | | EP | 4148446 | A4 | 18 October 2023 |
| | | | | JP | 2023-516317 | A | 19 April 2023 |
| | | | | JP | 7453402 | B2 | 19 March 2024 |
| | | | | KR | 10-2717091 | B1 | 11 October 2024 |
| | | | | US | 12032033 | B2 | 09 July 2024 |
| | | | | US | 2023-0108798 | A1 | 06 April 2023 |
| | | | | WO | 2022-025725 | A1 | 03 February 2022 |
| KR | 10-2010-0084935 | A | 28 July 2010 | None | | | |
| KR | 10-2105170 | B1 | 24 April 2020 | EP | 2866043 | A1 | 29 April 2015 |
| | | | | EP | 2866043 | B1 | 18 September 2019 |
| | | | | KR | 10-2105170 | B1 | 24 April 2020 |
| | | | | US | 09841462 | B2 | 12 December 2017 |
| | | | | US | 2015-0115971 | A1 | 30 April 2015 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240050745